# EUROPÄISCHE PATENTSCHRIFT

(11) **EP 0 740 316 B1**
(45) Veröffentlichungstag und Bekanntmachung des Hinweises auf die Patenterteilung: **22.10.1997**
(21) Anmeldenummer: 96105740.3
(22) Anmeldetag: 11.04.1996
(51) Int. Cl.: H01F 17/06, H03H 1/00

(54) **Stromkompensierte Funkentstördrossel mit erhöhter Streuinduktivität**
Current-compensated radio interference suppression choke with increased leakage inductance
Bobine de choc d'antiparasitage à compensation en courant à inductance de fuite augmentée

(30) Priorität: 27.04.1995 DE 19515494
(43) Veröffentlichungstag der Anmeldung: 30.10.1996
(73) Patentinhaber: Vacuumschmelze GmbH, 63450 Hanau (DE)
(72) Erfinder: Pöss, Hans-Joachim, Dipl.-Ing., 63571 Gelnhausen (DE)
(74) Vertreter: Fuchs, Franz-Josef, Dr.-Ing.

(56) Entgegenhaltungen:
- DE-A- 3 104 270
- DE-A- 3 621 573
- 1987 IEEE INTERNATIONAL SYMPOSIUM ON ELECTROMAGNETIC COMPATIBILITY, August 1987, ATLANTA, GEORGIA, Seiten 164-167, XP002009783 ALPHONSE A. TOPPETO: "Application and evaluation of EMI power line filters"

## Beschreibung

Die Erfindung betrifft eine stromkompensierte Funkentstördrossel mit konstruktiven Maßnahmen zur Erhöhung der Streuinduktivität und mit mindestens zwei vom Betriebsstrom durchflossenen Wicklungen, deren Wicklungssinn so gewählt ist, daß sich die durch den Betriebsstrom induzierten Magnetfelder gegenseitig kompensieren, während Erdströme, die sich über Eigenkapazitäten zur Erde schließen, sich ergänzende Magnetfelder erzeugen.

Eine derartige Funkentstördrossel ist beispielsweise in DE A 31 04 270 beschrieben. Auf einem Ringbandkern sind zwei Wicklungen aufgebracht, die in die elektrischen Zuleitungen zu einem Verbraucher eingeschaltet sind. Der Wicklungssinn der Wicklungen ist so gewählt, daß der Betriebsstrom in dem Ringbandkern Magnetfelder erzeugt, die einander entgegengerichtet sind. Dies hat zur Folge, daß eine Ummagnetisierung des Kerns durch den Betriebsstrom nicht erfolgt, so daß die Drosselwirkung in Bezug auf den Betriebsstrom vernachlässigbar klein ist.

Aufgabe dieser stromkompensierten Drossel ist es, gegenüber dem Betriebsstrom höherfrequente Störströme zu dämpfen. Hierbei unterscheidet man erdunsymmetrische Ströme, die sich über Eigenkapazitäten der Leitungen und des Verbrauchers zur Erde schließen. Diese Ströme erzeugen in dem Ringbandkern Magnetfelder, die sich ergänzen, so daß der Ringbandkern mit der Frequenz dieser Störströme ummagnetisiert wird und somit für diese Störströme eine starke Drosselwirkung hat. Außerdem können auch Störströme auftreten, die - wie der Betriebsstrom - durch die Zuleitungen über den Verbraucher zurück zum Netz fließen. Diese Störströme fließen durch die Wicklungen auf dem Ringbandkern in gleicher Weise wie der Betriebsstrom, so daß sich deren Magnetfelder im Ringbandkern aufheben. Um auch hier eine Dämpfung zu erreichen, ist beispielsweise in der Umgebung des Ringbandkerns magnetisch leitendes Material vorgesehen, so daß die Streuinduktivität der aus dem Ringbandkern mit den Wicklungen bestehenden stromkompensierten Drossel erhöht wird und so auch eine Dämpfung der dem Betriebsstrom überlagerten erdsymmetrischen Ströme erzielt wird.

Aufgabe der vorliegenden Erfindung ist es, eine Anordnung für eine derartige stromkompensierte Drossel anzugeben, die eine weitere Verbesserung der Dämpfung sowohl für die dem Betriebsstrom überlagerten Störströme erbringt, als auch durch die Möglichkeit, eine erhöhte Windungszahl für die Drosselwicklungen vorzusehen, die Dämpfung der sich über Erde schließenden Störströme zu verbessern.

Die Lösung besteht erfindungsgemäß darin, daß jede der Wicklungen (W1, W2) auf je einen in sich geschlossenen Kern (K1, K2) aus weichmagnetischem Material gewickelt ist und daß die mit den Wicklungen versehenen Kerne (K1, K2) miteinander über je eine Koppelwicklung (W3) verbunden sind.

Ein Ausführungsbeispiel ist für einen einphasigen Verbraucher in Fig. 1 und für einen dreiphasigen Verbraucher in Fig. 2 dargestellt; Fig. 3 zeigt als Diagramm den Dämpfungsverlauf über der Frequenz im Vergleich zu einer Anordnung für eine stromkompensierte Drossel unter Verwendung eines einzigen Kernes für Ströme, die dem Betriebsstrom überlagert sind und Fig. 4 ein Diagramm mit dem entsprechenden Dämpfungsverlauf für Störströme, die sich über Erde schließen.

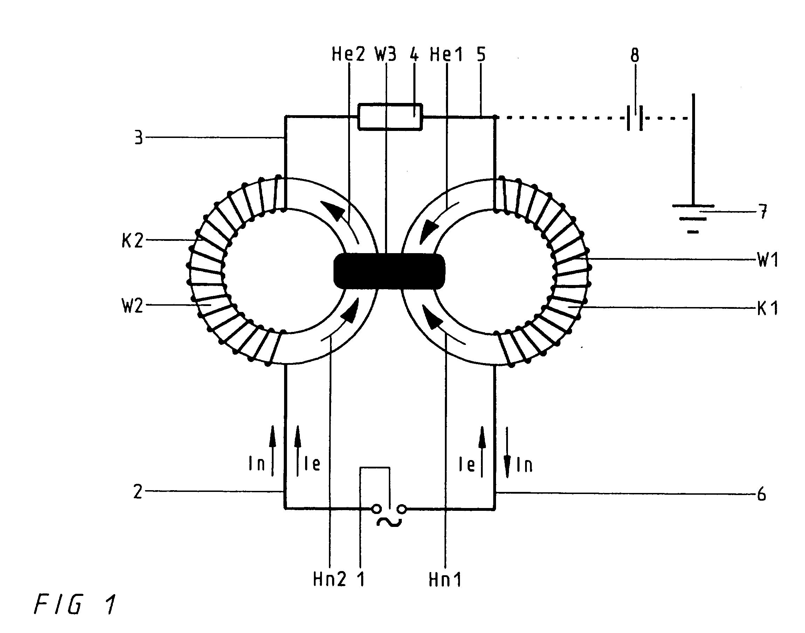

In Fig. 1 ist eine Wechselspannungsquelle 1 über eine Leitung 2, eine Wicklung W2 und eine Leitung 3 an einen als Widerstand dargestellten Verbraucher 4 angeschlossen. Die Rückleitung vom Verbraucher 4 zum anderen Pol der Wechselspannungsquelle erfolgt über eine Leitung 5, eine Wicklung W1 sowie eine Leitung 6. Die Wicklungen W1 und W2 sind die Wicklungen einer stromkompensierten Drossel. Dabei ist die Wicklung W1 auf einen Kern K1 und die Wicklung W2 auf einen Kern K2 aufgewickelt. Die Kerne sind miteinander über eine kurzgeschlossene Koppelwicklung W3 verbunden, die aus einer oder mehreren Windungen bestehen kann und vorteilhafterweise auch als Steckverbindung von U-förmigen oder Halbkreisförmigen Massivteilen ausgeführt werden kann. Zwischen der Leitung 3 und Erde 7 ist über gestrichelte Linien ein Kondensator 8 angedeutet, der beispielsweise die Eigenkapazität des Verbrauchers 4 mit den angeschlossenen Leitungen 3 und 5 darstellt.

Die Funktionsweise dieser Anordnung ist folgende: Der Betriebsstrom I*n* fließt - beispielsweise in einer bestimmten Halbwelle - in der durch einen Pfeil angegebenen Richtung über die Leitung 2 durch die Wicklung W2 und die Leitung 3 zum Verbraucher 4 . Dabei wird das Feld H*n*2 erzeugt. Der vom Verbraucher zurückfließende Strom I*n* fließt dann in der ebenfalls durch Pfeil angegebenen Richtung durch die Wicklung W1 und die Leitung 6 zur Wechselspannungsquelle 1 zurück. Dabei entsteht das Feld H*n*1 im Kern K1 und das Feld H*n*2 im Kern K2. Diese Felder bewirken eine Magnetfeldänderung im Innern der Koppelwicklung W3 und erzeugen damit in dieser Wicklung einen Strom, der wegen des geringen Widerstandes ein den Feldern H*n*1 und H*n*2 entgegengesetzt gerichtetes Magnetfeld in den Kernen K1 und K2 erzeugt, so daß tatsächlich in keinem der Kerne ein nennenswertes Feld aufgebaut wird.

Wird jetzt dem Betriebsstrom I*n* durch äußere Störeinflüsse ein in gleicher Weise fließender Strom überlagert, der sich vom Betriebsstrom nur durch eine höhere Frequenz unterscheidet, so treten bei gleicher Polarität die gleichen Feldrichtungen auf.

In Bezug auf den hochfrequenten Störstrom macht sich in der Koppelwicklung W3 jedoch der Skineffekt bemerkbar, d. h. der Widerstand der Koppelwicklung W3 ist in Bezug auf hochfrequente Störströme größer als in Bezug auf den relativ niederfrequenten Betriebsstrom. Der so erhöhte Widerstand der Koppelwicklung W3 bewirkt, daß in der Wicklung eine höhere Spannung induziert werden muß, als dies beim Betriebsstrom der Fall ist. Die Spannung bedingt aber eine Magnetfeldänderung im Innern der Koppelwicklung W3 mit der Frequenz des Störstromes, so daß beide Wicklungen W1 und W2 in Bezug auf den Störstrom eine wesentlich höhere Drosselwirkung haben als in Bezug auf den Betriebsstrom.

Es kommt hinzu, daß die voneinander abgewandten Seiten der beiden Kerne K1 und K2 mit den Wicklungen W1 und W2 versehen sind. Dieser Abstand zwischen den Wicklungen vermindert deren Kopplung, so daß die Gesamtanordnung - auch durch die konstruktive Ausgestaltung - eine Erhöhung der Streuinduktivität erfährt. Weitere Erhöhungen der Streuinduktivität sind bei dieser Anordnung zusätzlich wie beim Bekannten noch dadurch möglich, daß magnetisch leitende Teile in der Nähe der Kerne K1 und K2 angebracht werden, so daß sich der durch die Wicklungen W1 bzw. W2 erzeugte Magnetfluß auch außerhalb der Kerne K1 und K2 schließen kann. Eine weitere Maßnahme zur Erhöhung der Streuinduktivität kann darin bestehen, daß die Koppelwicklung einen weiteren, ohne sonstige Wicklung vorgesehenen Kern umschließt. Hierdurch ergibt sich der besondere Vorteil, daß dieser Kern nur dann ummagnetisiert wird, wenn die Summe der durch die Wicklungen W1, W2 in der Koppelwicklung W3 erzeugten Felder nicht null ist.

Für die Erdströme, von denen die Polarität einer Halbwelle durch die mit I*e* bezeichneten Pfeile gekennzeichnet ist, ergeben sich - da sie über die Eigenkapazität (Kondensator 8) zur Erde fließen, die mit H*e*1 und H*e*2 gekennzeichneten Feldverläufe in den Kernen K1 und K2. Man sieht, daß diese Felder innerhalb der Koppelwicklung W3 jeweils unterschiedliche Richtungen haben, so daß die gesamte Feldänderung im Innern der Koppelwicklung W3 null ist. Die Koppelwicklung behindert also in diesem Fall nicht die Ausbildung von Magnetfeldern in den Kernen K1 und K2, so daß eine relativ hohe Dämpfung dieser sich über Erde schließenden Ströme vorhanden ist. Da die Koppelwicklung wenig Platz im Kern benötigt, läßt sich bei gleicher Kernabmessung die Windungszahl der Wicklungen W1 und W2 erhöhen und damit eine weitere Verbesserung der Dämpfung für diese Ströme erreichen.

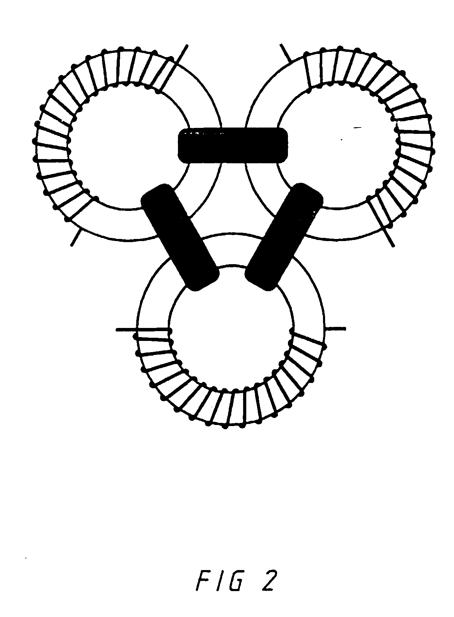

Fig. 2 zeigt die Anordnung für dreiphasige Systeme. Hier sind drei Wicklungen mit je drei Kernen vorgesehen, wobei jedes Kernpaar durch eine Koppelwicklung miteinander verbunden ist. In entsprechender Weise können bei mehr als dreiphasigen Systemen entsprechend erweiterte Anordnungen vorgesehen werden.

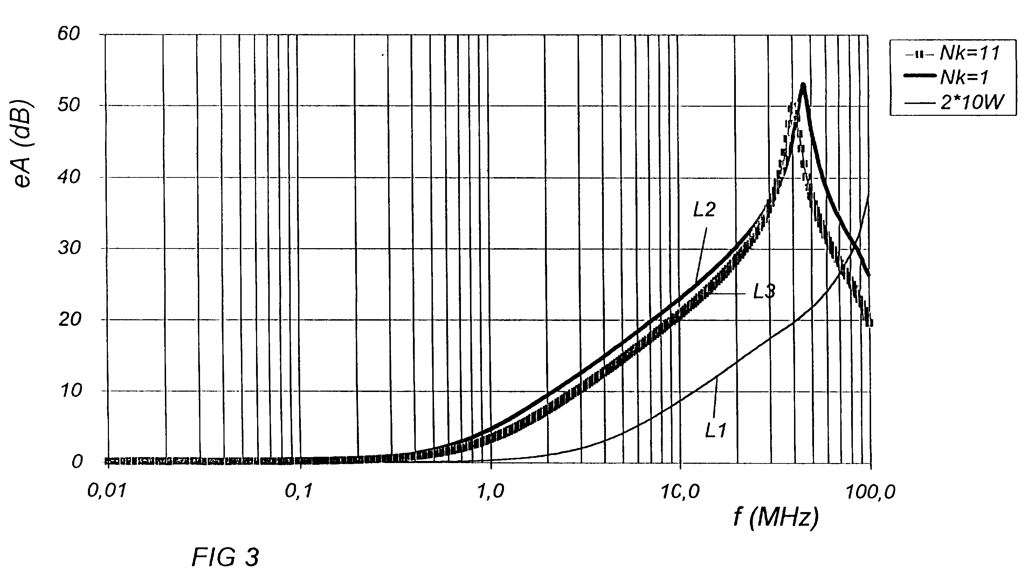

Fig. 3 zeigt ein Diagramm mit der Dämpfung in dB auf der Ordinate und auf der Abszisse die Frequenz in MHz. Hierbei bezieht sich die Kennlinie L1 auf eine bekannte Anordnung, bei der beide Wicklungen W1 und W2 auf einen gemeinsamen Kern aufgewickelt sind. Die Kennlinie L2 ergibt die Dämpfung bei der erfindungsgemäßen Anordnung mit zwei Wicklungen W1 und W2 und zwei Kernen K1 und K2 für den Fall, daß die Koppelwicklung W3 nur eine einzige Windung enthält. Die Kennlinie L3 zeigt die Verhältnisse, wenn die Koppelwicklung W3 nicht eine, sondern elf Windungen aufweist.

Man sieht, daß die dem Betriebsstrom überlagerten hochfrequenten Störströme über weite Bereiche eine wesentlich bessere Dämpfung erfahren, als dies bei der Vergleichskennlinie L1 mit einem Kern der Fall ist. Lediglich bei sehr hohen Frequenzen ist - bedingt durch Resonanzen - in einem schmalen Bereich eine verringerte Dämpfung gegeben.

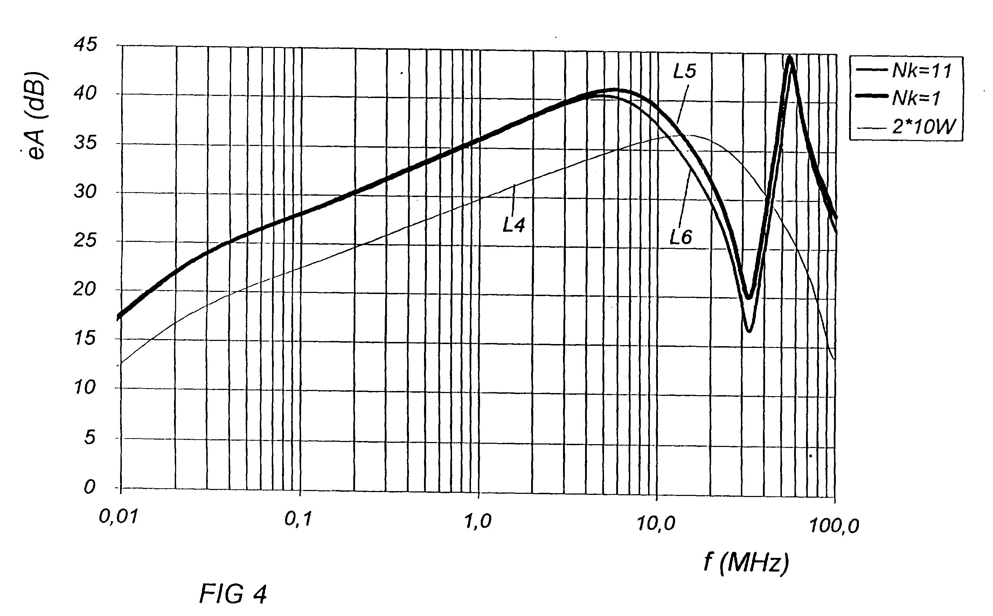

Fig. 4 läßt ebenfalls eine wesentlich bessere Dämpfung über weite Frequenzbereiche erkennen. Hier ist die Dämpfung über der Frequenz für Ströme aufgezeichnet, die sich über Erde schließen. Die Kennlinie L4 ist wieder die Vergleichskennlinie für eine bekannte Anordnung, während die Kennlinie L5 die erfindungsgemäße Anordnung mit zwei Kernen und einer Koppelwicklung mit einer Windung kennzeichnet. Die Kennlinie L6 gilt für die erfindungsgemäße Anordnung mit elf Windungen für die Koppelwicklung W3.

## Patentansprüche

1. Stromkompensierte Funkentstördrossel mit konstruktiven Maßnahmen zur Erhöhung der Streuinduktivität und mit mindestens zwei vom Betriebsstrom durchflossenen Wicklungen (W1, W2), deren Wicklungssinn so gewählt ist, daß sich die durch den Betriebsstrom (I*n*) induzierten Magnetfelder (H*n*1, H*n*2) gegenseitig kompensieren, während Erdströme (Ie), die sich über Eigenkapazitäten zur Erde schließen, sich ergänzende Magnetfelder (H1e, H2e) erzeugen, dadurch gekennzeichnet, daß jede der Wicklungen (W1, W2) auf je einen in sich geschlossenen Kern (K1, K2) aus weichmagnetischem Material gewickelt ist und daß die mit den Wicklungen (W1, W2) versehenen Kerne (K1, K2) miteinander über je eine Koppelwicklung (W3) verbunden sind.

2. Stromkompensierte Funkentstördrossel nach Anspruch 1, dadurch gekennzeichnet, daß die Koppelwicklung (W3) aus einer einzigen Windung besteht.

3. Stromkompensierte Funkentstördrossel nach Anspruch 1, dadurch gekennzeichnet, daß die in sich geschlossenen Kerne (K1, K2) aus weichmagnetischen Blechen gewickelte Ringbandkerne sind.

4. Stromkompensierte Funkentstördrossel nach Anspruch 1, dadurch gekennzeichnet, daß zur Funkentstörung von Dreiphasen-Strom drei in sich geschlossene Kerne und drei jeden Kern mit jedem anderen verbindenden Koppelwicklung vorgesehen sind.

5. Stromkompensierte Funkentstördrossel nach Anspruch 1, oder einem der nachfolgenden Ansprüche, dadurch gekennzeichnet, daß die in sich geschlossenen Kerne (K1, K2) durch die Koppelwicklung (W3) dicht nebeneinander gehalten werden, und daß die vom Betriebsstrom durchflossenen Wicklungen (W1) und (W2) auf den der Koppelwicklung abgewandten Seiten der Kerne aufgewickelt sind.

6. Stromkompensierte Funkentstördrossel nach einem oder mehreren der vorhergehenden Ansprüche, dadurch gekennzeichnet, daß die Koppelwicklung (W3) aus ineinander gesteckten massiven Kupferteilen besteht.

7. Stromkompensierte Funkentstördrossel nach einem der vorhergehenden Ansprüche, dadurch gekennzeichnet, daß die Koppelwicklung (W3) zusätzlich zu den mit vom Betriebsstrom durchflossenen Wicklungen (W1, W2) versehenen Kernen (K1, K2) zur weiteren Erhöhung der Streuinduktivität einen weiteren in sich geschlossenen Magnetkern umschließt.

8. Stromkompensierte Funkentstördrossel nach Anspruch 1 und 4, dadurch gekennzeichnet, daß in die Nähe der Kerne (K1, K2) zusätzlich weiteres magnetisch leitendes Material vorgesehen ist.

## Claims

1. Current-compensated radio interference suppression inductor having design measures to increase the leakage inductance and having at least two windings (W1, W2) through which the operating current flows and whose winding sense is chosen such that the magnetic fields (H*n*1, H*n*2) which are induced by the operating current (I*n*) compensate for one another, while earth currents (Ie), which lead to earth via parasitic capacitances produce complementary magnetic fields (H1e, H2e), characterized in that each of the windings (W1, W2) is wound on in each case one intrinsically closed core (K1, K2) made of soft-magnetic material, and in that the cores (K1, K2), which are provided with the windings (W1, W2), are connected to one another via in each case one coupling winding (W3).

2. Current-compensated radio interference suppression inductor according to Claim 1, characterized in that the coupling winding (W3) is composed of a single turn.

3. Current-compensated radio interference suppression inductor according to Claim 1, characterized in that the intrinsically closed cores (K1, K2) are annular strip cores wound from soft-magnetic laminates.

4. Current-compensated radio interference suppression inductor according to Claim 1, characterized in that three intrinsically closed cores and three coupling windings, which connect each core to every other core, are provided for radio suppression of three-phase currents.

5. Current-compensated radio interference suppression inductor according to Claim 1, or one of the following claims, characterized in that the intrinsically closed cores (K1, K2) are held closely alongside one another by the coupling winding (W3), and in that the windings (W1) and (W2) through which the operating current flows are wound on the sides of the cores facing away from the coupling winding.

6. Current-compensated radio interference suppression inductor according to one or more of the preceding claims, characterized in that the coupling winding (W3) is composed of solid copper parts which are plugged into one another.

7. Current-compensated radio interference suppression inductor according to one of the preceding claims, characterized in that, in order to increase the leakage inductance further, the coupling winding (W3) encloses a further intrinsically closed magnet core in addition to the cores (K1, K2) provided with windings (W1, W2) through which the operating current flows.

8. Current-compensated radio interference suppression inductor according to Claims 1 and 4, characterized in that further magnetically permeable material is additionally provided in the vicinity of the cores (K1, K2).

## Revendications

1. Bobine d'antiparasitage à compensation en courant comportant des mesures structurales destinées à accroître l'inductance de fuite et disposant d'au moins deux enroulements (W1, W2) parcourus par le courant de service et dont le sens d'enroulement est choisi de telle sorte que les champs magnétiques (H*n*l, H*n*2) induits par le courant de service (I*n*) se compensent mutuellement, tandis que les courants à la terre (l*e*) qui sont connectés à la terre au moyen de capacités propres créent des champs magnétiques (H1e, H2e) complémentaires, caractérisée en ce que chacun des enroulements (W1, W2) est enroulé sur un noyau (K1, K2) refermé sur lui-même et fabriqué en un matériau magnétiquement doux, et en ce que les noyaux (K1, K2) munis des enroulements (W1, W2) sont chacun reliés entre eux par une bobine de couplage (W3).

2. Bobine d'antiparasitage à compensation en courant selon la revendication 1, caractérisée en ce que la bobine de couplage (W3) comporte une seule spire.

3. Bobine d'antiparasitage à compensation en courant selon la revendication 1, caractérisée en ce que les noyaux (K1, K2) refermés sur eux-mêmes sont des noyaux à bande enroulée en tôles magnétiquement douces.

4. Bobine d'antiparasitage à compensation en courant selon la revendication 1, caractérisée en ce que pour l'antiparasitage du courant triphasé, on prévoit d'utiliser trois noyaux refermés sur eux-mêmes et trois bobines de couplage reliant chaque noyau à chacun des autres.

5. Bobine d'antiparasitage à compensation en courant selon la revendication 1, ou selon l'une des revendications suivantes, caractérisée en ce que les noyaux (K1, K2) refermés sur eux-mêmes sont maintenus très proches l'un de l'autre par la bobine de couplage (W3), et en ce que les enroulements (W1 et W2) qui sont parcourus par le courant de service sont enroulés sur les faces des noyaux opposées à ceux de la bobine de couplage.

6. Bobine d'antiparasitage à compensation en courant selon une ou plusieurs des revendications précédentes, caractérisée en ce que la bobine de couplage (W3) est constituée de pièces en cuivre massif enfoncées les unes dans les autres.

7. Bobine d'antiparasitage à compensation en courant selon l'une des revendications précédentes, caractérisée en ce que la bobine de couplage (W3) entoure - outre les noyaux (K1, K2) munis des enroulements (W1, W2) qui sont parcourus par le courant de service - un autre noyau magnétique refermé sur lui-même, afin de provoquer une augmentation supplémentaire de l'inductance de fuite.

8. Bobine d'antiparasitage à compensation en courant selon les revendications 1 et 4, caractérisée en ce qu'un autre matériau conducteur magnétique supplémentaire est prévu à proximité des noyaux (K1, K2).
